# DEMANDE DE BREVET EUROPEEN

(11) **EP 4 651 170 A1**
(43) Date de publication de la demande: **19.11.2025**
(21) Numéro de dépôt: 25176997.2
(22) Date de dépôt: 16.05.2025
(51) Int. Cl.: H01H 71/04

(54) **DISPOSITIF ACOUSTIQUE POUR L'ESTIMATION D'UNE INTENSITÉ DE DÉCLENCHEMENT, ENSEMBLE DE PROTECTION ÉLECTRIQUE ET INSTALLATION ÉLECTRIQUE ASSOCIÉS**

(30) Priorité: 17.05.2024 FR 2405098
(71) Demandeur: SCHNEIDER ELECTRIC INDUSTRIES SAS, 92500 Rueil-Malmaison (FR)
(72) Inventeur: LANES, David, 38660 SAINT HILAIRE DU TOUVET (FR); GRUMEL, Christophe, 38250 LANS EN VERCORS (FR); LAYDEVANT, Nicolas, 38100 GRENOBLE (FR)
(74) Mandataire: Lavoix

(57) **Abrégé**

La présente invention concerne un dispositif acoustique pour l'estimation d'une intensité de déclenchement d'un courant de déclenchement circulant dans un disjoncteur, le dispositif comprenant :
- une enveloppe (22) ;
- une plaque (32) ;
- un support (40), une languette (42) reliant le support et la plaque ;
- un microphone (70) ;
- un atténuateur (44), le support s'étendant entre le microphone et l'atténuateur, l'atténuateur comprenant un logement (46) comprenant un orifice de logement (48) et une membrane d'atténuation (50), et
- une unité électronique de contrôle (38), connectée au microphone,
l'atténuateur étant configuré pour atténuer un bruit généré par le disjoncteur, le bruit étant représentatif de l'intensité de déclenchement, le microphone étant configuré pour mesurer le bruit atténué par l'atténuateur, et pour émettre un signal de sortie et l'unité électronique de contrôle étant configurée pour recevoir le signal de sortie et pour estimer l'intensité de déclenchement.

## Description

La présente invention concerne un dispositif acoustique pour l'estimation d'une intensité de déclenchement, un ensemble de protection électrique et une installation électrique associés.

Afin de surveiller le fonctionnement d'un disjoncteur et de prévoir des opérations de maintenance prédictives, il est connu de mesurer l'intensité du courant qui circule au travers du disjoncteur au moment où le disjoncteur bascule en configuration déclenchée, c'est-à-dire devient isolant électriquement. Le courant qui circule au travers du disjoncteur au moment où le disjoncteur bascule en configuration déclenchée est appelé courant de déclenchement, et a une intensité dite intensité de déclenchement.

Cependant la mesure de l'intensité de déclenchement est coûteuse et intrusive, puisqu'elle nécessite d'ajouter un capteur d'intensité à l'intérieur du disjoncteur, plus précisément sur l'un des conducteurs du disjoncteur, ce capteur devant être capable de résister aux intensités de déclenchement dont les valeurs peuvent être élevées.

US5844493A décrit un microphone intégré dans un dispositif de protection électrique pour détecter un court-circuit.

Le but de l'invention est alors de proposer un dispositif permettant d'estimer l'intensité de déclenchement de manière simple, non intrusive et à faible coût.

A cet effet, l'invention a pour objet un dispositif acoustique pour l'estimation d'une intensité de déclenchement d'un courant de déclenchement circulant dans un disjoncteur, le dispositif comprenant :
- une enveloppe configurée pour être fixée au disjoncteur ;
- une plaque, intégrée à l'intérieur de l'enveloppe, la plaque s'étendant selon un plan principal ;
- un support, intégré à l'intérieur de l'enveloppe, le support s'étendant parallèlement au plan principal, une languette reliant le support et la plaque, le support étant relié à la plaque uniquement par l'intermédiaire de la languette ;
- un microphone, fixé au support ;
- un atténuateur, fixé au support, le support s'étendant entre le microphone et l'atténuateur, l'atténuateur comprenant :
   o un logement comprenant un orifice de logement, traversant et s'étendant selon un axe de logement, et
   o une membrane d'atténuation, reçue dans le logement et recouvrant l'orifice de logement ; et
- une unité électronique de contrôle, connectée au microphone,

l'atténuateur étant configuré pour atténuer un bruit généré par le disjoncteur, le bruit étant représentatif de l'intensité de déclenchement, le microphone étant configuré pour mesurer le bruit atténué par l'atténuateur, et pour émettre un signal de sortie représentatif du bruit atténué, et l'unité électronique de contrôle étant configurée pour recevoir le signal de sortie émis par le microphone et pour estimer l'intensité de déclenchement du courant de déclenchement du disjoncteur, à partir du signal de sortie.

Grâce à l'invention, l'estimation de l'intensité de déclenchement en utilisant le bruit émis par le disjoncteur est simple, non intrusive et peu coûteuse. En effet, comme le bruit émis par le disjoncteur est représentatif de l'intensité de déclenchement, estimer l'intensité de déclenchement à partir du bruit mesuré par le microphone est une solution simple et peu coûteuse. De plus, le microphone ne nécessite pas d'être intégré au disjoncteur pour fonctionner. L'atténuateur, en particulier grâce à la membrane d'atténuation, permet d'atténuer le bruit émis par le disjoncteur jusqu'à des niveaux sonores qui peuvent être mesurés par le microphone, tout en offrant une atténuation constante sur la plage de fréquences composant le bruit. Ceci permet de limiter les risques de saturation et d'endommagement du microphone tout en permettant au microphone d'enregistrer un bruit atténué qui est représentatif de l'intensité de déclenchement, afin que l'unité électronique estime l'intensité de déclenchement avec la meilleure précision possible.

Le fait que le support soit relié à la plaque uniquement par l'intermédiaire de la languette permet d'amortir les vibrations mécaniques générées par le disjoncteur et transmises au dispositif, afin de limiter que leur mesure par le microphone masque le bruit atténué et empêche une estimation correcte de l'intensité de déclenchement.

Suivant d'autres aspects avantageux de l'invention, le dispositif acoustique comprend une ou plusieurs des caractéristiques suivantes, prises isolément ou suivant toutes les combinaisons techniquement possibles :
- L'atténuateur comprend en outre une rondelle, comprenant un orifice de rondelle, l'orifice de rondelle étant traversant et s'étendant selon un axe de rondelle, la rondelle étant reçue dans le logement de sorte que les axes de logement et de rondelle coïncident, la rondelle étant en contact avec la membrane d'atténuation, et la membrane d'atténuation recouvrant l'orifice de rondelle.
- Le dispositif comprend en outre un amortisseur mécanique, fixé à l'enveloppe, entourant le support et l'atténuateur, et laissant libre le microphone et l'orifice de logement, l'amortisseur mécanique étant configuré pour amortir des vibrations mécaniques du dispositif.

- L'enveloppe comprend une cale, la languette étant en appui contre la cale afin de positionner le support à distance de la plaque selon un axe perpendiculaire au plan principal.
- Le support comprend un orifice de support, l'orifice de support étant traversant selon un axe de support ;
   - le microphone est fixé sur le support de manière à recouvrir l'orifice de support ; et
   - l'atténuateur est fixé au support de sorte que les axes de logement, de rondelle et de support coïncident.
- L'enveloppe comprend un port acoustique, comprenant au moins une ouverture, le support est en regard du port acoustique et l'atténuateur est disposé entre le support et le port acoustique.
- L'atténuateur est fixé au support par un film adhésif, le film adhésif comprenant au moins deux couches adhésives et au moins une membrane, interposée entre deux parmi les au moins deux couches adhésives, une des au moins deux couches adhésives étant collée à l'atténuateur et une autre des au moins deux couches adhésives étant collée au support.
- La ou chaque membrane comprend des fibres tissées.
- La ou chaque membrane comprend des fibres non tissées.

L'invention concerne également un ensemble de protection électrique comprenant un disjoncteur, le disjoncteur étant configuré pour être connecté entre une source et une charge, et étant configuré pour basculer d'une configuration armée, dans laquelle le disjoncteur conduit un courant circulant entre la source et la charge, à une configuration déclenchée, dans laquelle le disjoncteur isole électriquement la charge de la source, lorsqu'un courant de déclenchement d'intensité l'intensité de déclenchement circule dans le disjoncteur, le basculement du disjoncteur de la configuration armée à la configuration déclenchée générant un bruit, représentatif de l'intensité de déclenchement, le disjoncteur comprenant un boîtier, l'ensemble de protection électrique comprenant en outre un dispositif ainsi que décrit précédemment, l'enveloppe du dispositif étant fixée sur le boîtier.

L'invention concerne également une installation électrique comprenant une source, une charge connectée à la source et un ensemble de protection électrique, connecté entre la source et la charge.

L'invention apparaîtra plus clairement à la lecture de la description qui va suivre, donnée uniquement à titre d'exemple non limitatif, et faite en référence aux dessins dans lesquels :
- [Fig. 1] la figure 1 est une vue d'une installation électrique selon l'invention ;
- [Fig. 2] la figure 2 est une coupe d'un dispositif de protection selon l'invention ;
- [Fig. 3] la figure 3 est une vue éclatée d'éléments du dispositif de protection ;
- [Fig. 4] la figure 4 est une vue d'un détail du dispositif de protection selon le plan IV-IV.

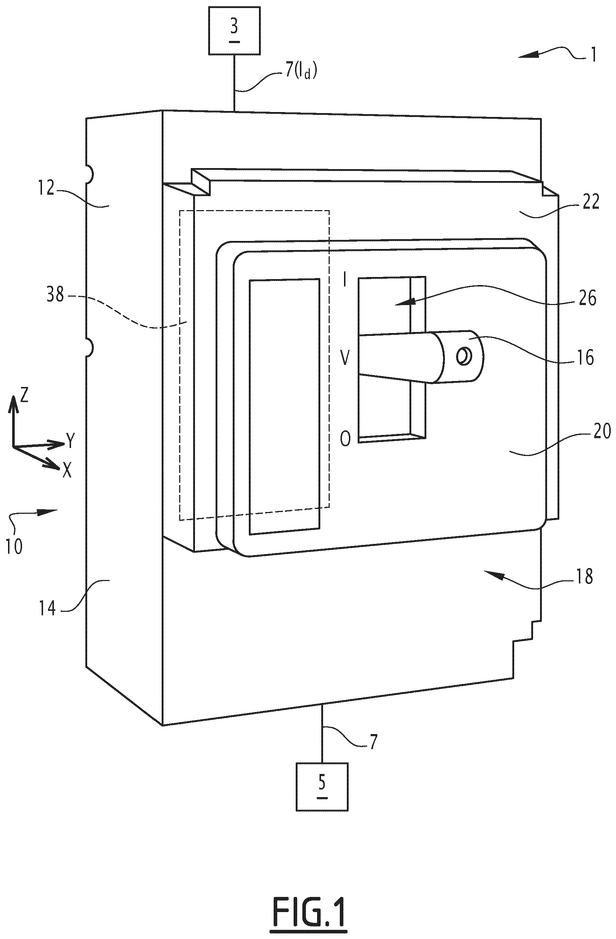

La figure 1 représente une installation électrique 1, comprenant une source 3 et une charge 5. La source 3 fournit de l'électricité et est, par exemple, un générateur électrique, un transformateur ou un réseau électrique comme un réseau électrique de secteur. La charge 5 est un appareil consommant de l'électricité, par exemple un équipement industriel comme un moteur électrique, un serveur, ou un équipement domestique.

Dans l'exemple de la figure 1, la source 3 et la charge 5 sont reliées entre elles par un conducteur de phase 7, mais en variante, la source et la charge sont reliées entre elles par plus d'un conducteur de phase, par exemple trois conducteurs de phase. Un courant électrique, dit aussi simplement courant, fourni par la source 3, circule entre la source 3 et la charge 5 à travers le conducteur de phase 7. Le courant électrique est avantageusement un courant électrique basse tension, c'est-à-dire de tension nominale inférieure ou égale à 1500V. Le courant est avantageusement un courant alternatif. En variante, le courant est un courant continu.

Avantageusement, et de manière non représentée, la source 3 et la charge 5 sont reliées entre elles en outre par un conducteur de neutre.

L'installation électrique 1 comprend un ensemble de protection électrique 10, connecté entre la source 3 et la charge 5. L'ensemble de protection électrique 10 comprend un disjoncteur 12, qui est connecté entre la source 3 et la charge 5. Ainsi, le courant circulant de la source 3 à la charge 5 par le conducteur de phase 7 circule également dans le disjoncteur 12. Le disjoncteur 12 est, par exemple, ainsi que représenté à la figure 1, un disjoncteur à boîtier moulé, ou MCCB, de l'anglais « Molded Case Circuit Breaker ».

Le disjoncteur 12 comprend un boîtier 14, qui est dans un matériau isolant électriquement. Le boîtier 14 contient la majorité des autres composants du disjoncteur 12, notamment des contacts du disjoncteur, non représentés.

Le disjoncteur 12 est configuré pour basculer entre une configuration armée, dans laquelle les contacts sont fermés, et dans laquelle il conduit le courant circulant entre la source 3 et la charge 5, et une configuration déclenchée, dans laquelle les contacts sont ouverts et dans laquelle il isole électriquement la source 3 de la charge 5. Le disjoncteur 12 est configuré pour basculer en configuration déclenchée en cas de court-circuit ou de surcharge de l'installation électrique 1, afin d'éviter qu'un courant trop important ne circule dans l'installation électrique 1. Le disjoncteur 12 est également configuré pour basculer en configuration déclenchée suite à une commande de l'utilisateur, par exemple qui le bascule manuellement en configuration déclenchée en actionnant une manette 16 du disjoncteur 12. Lorsque le disjoncteur 12 bascule en configuration déclenchée, le courant circulant dans le disjoncteur 12 est dit courant de déclenchement, et est caractérisé par une intensité de déclenchement I_{d}. L'intensité de déclenchement I_{d} est variable en fonction de la raison du basculement du disjoncteur 12 en configuration déclenchée, et peut varier de sensiblement nulle, par exemple dans le cas où l'utilisateur commande le basculement du disjoncteur 12 en configuration déclenchée, à supérieure à 2500A, par exemple dans le cas de courts-circuits.

Dans l'exemple de la figure 1, la manette 16 dépasse d'une face avant 18 du boîtier 14. La face avant 18 est perpendiculaire à un axe de profondeur X, lié au disjoncteur 12. Un axe de largeur Y et un axe de hauteur Z sont associés à l'axe de profondeur X, les trois axes formant un trièdre direct. La face avant 18 s'étend ainsi selon les axes de largeur Y et de hauteur Z.

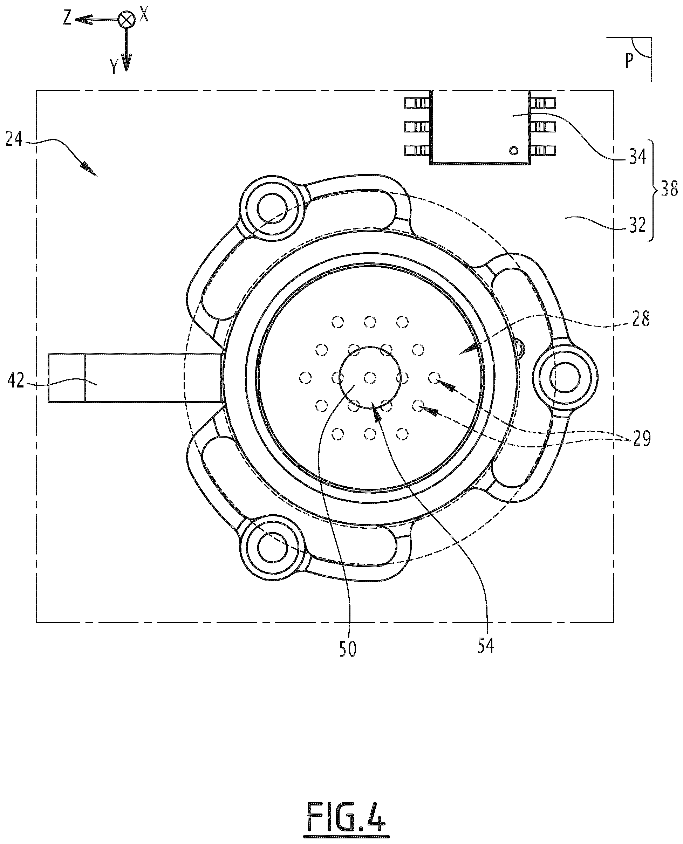

L'ensemble électrique 10 comprend également un dispositif acoustique 20 pour l'estimation de l'intensité de déclenchement I_{d}. Le dispositif 20 comprend une enveloppe 22, fixée au disjoncteur 12. Plus précisément, l'enveloppe 22 est fixée au boîtier 14, par exemple en étant collée ou vissée au boîtier 14. Dans l'exemple de la figure 1, l'enveloppe 22 comprend une face dite face arrière 24, partiellement visible à la figure 4, qui est en contact avec la face avant 18. En variante, la face arrière 24 de l'enveloppe 22 est à une distance de l'ordre de quelques millimètres de la face avant 18 du boîtier 14, mesurée selon l'axe de profondeur X. L'enveloppe 22 comprend un orifice 26, qui la traverse de part en part afin de laisser libre la manette 16, qui peut ainsi se déplacer lorsque le disjoncteur 12 se déclenche, lorsqu'il est réarmé par l'utilisateur, ou lorsque l'utilisateur actionne la manette 16 pour déclencher manuellement le disjoncteur 12.

De manière avantageuse, l'enveloppe 22 comprend un port acoustique 28, visible à la figure 4. Dans l'exemple des figures 1 et 4, le port acoustique 28 est localisé sur la face arrière 24, de sorte à être en contact avec la face avant 22, ou du moins, le plus proche possible du disjoncteur 12. Le port acoustique 28 comprend au moins une ouverture 29, dans l'exemple de la figure 4, une pluralité d'ouvertures 29, reliant l'intérieur de l'enveloppe 22, à l'extérieur. De l'air peut ainsi circuler de l'extérieur à l'intérieur de l'enveloppe 22 à travers les ouvertures 29 et inversement.

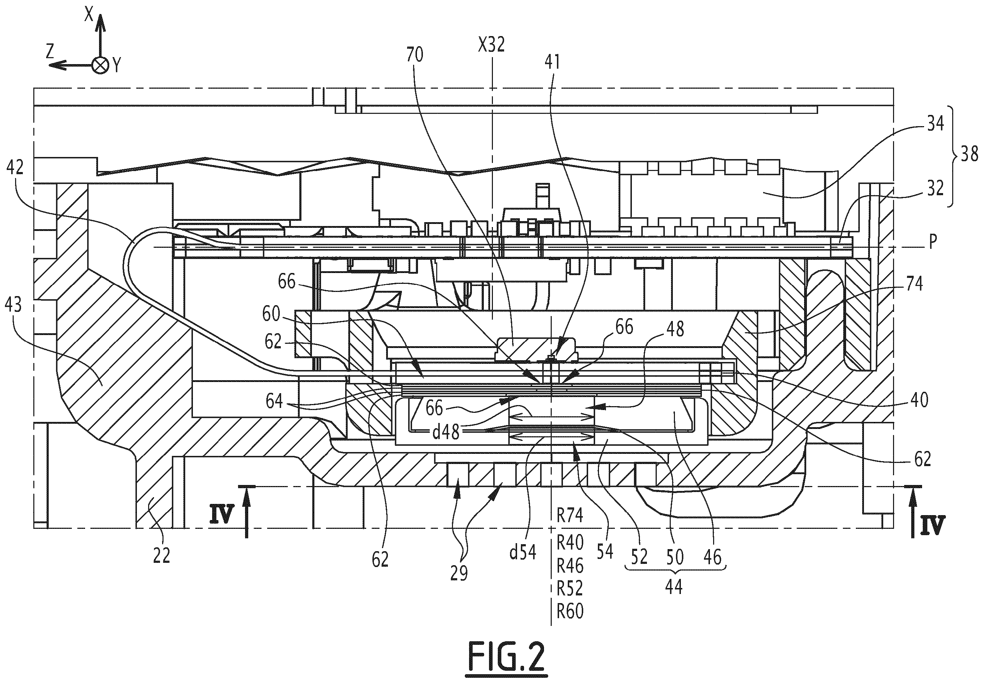

Le dispositif 20 comprend en outre une plaque 32, visible aux figures 2 et 4, intégrée à l'intérieur de l'enveloppe 22. La plaque 32 s'étend selon un plan principal P, qui, dans l'exemple des figures 2 et 4, est perpendiculaire à l'axe de profondeur X.

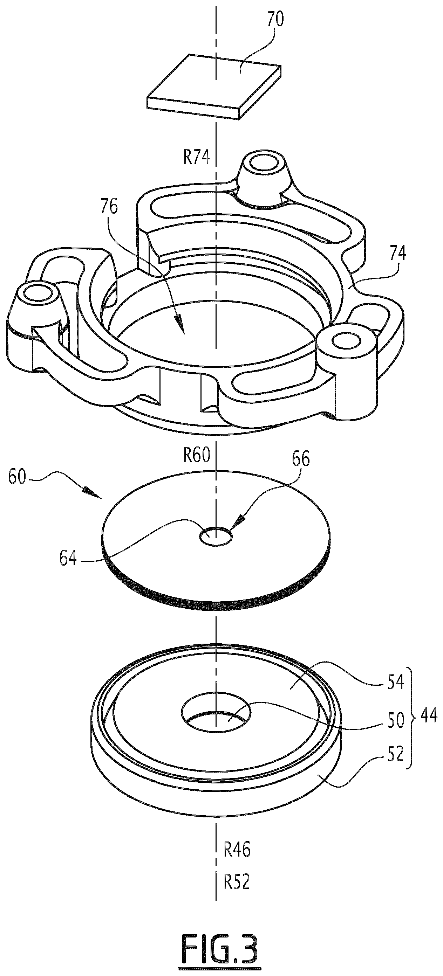

La plaque 32 est, par exemple, un circuit imprimé, sur lequel sont connectés des composants électroniques 34, comme des composants logiques programmables, tel que des FPGA (de l'anglais *Field Programmable Gate Array*), ou encore des circuits intégrés, tels que des ASIC (de l'anglais *Application Specific Integrated Circuit*) le circuit imprimé et les composants électroniques 34 formant une unité électronique de contrôle 38, représentée en pointillés sur la figure 1, et partiellement sur les figures 2 et 3 dont la fonction est décrite en détail plus loin.

Le dispositif 20 comprend un support 40, intégré à l'intérieur de l'enveloppe 22 et visible sur la figure 2. Dans l'exemple de la figure 2, le support 40 est circulaire, et s'étend parallèlement au plan principal P. Le support 40 est par exemple un circuit imprimé. Avantageusement, le support 40 comprend un orifice de support 41, traversant et s'étendant selon un axe de support R40.

De manière avantageuse, le support 40 est à distance de la plaque 32 selon un axe X32, perpendiculaire au plan principal P.

Le support 40 est relié à la plaque 32 par l'intermédiaire d'une languette 42. Le support 40 n'est relié à la plaque 32 que par l'intermédiaire de cette languette 42. La languette 42 est avantageusement en polymère flexible, par exemple en polyimide, ou en variante, la languette 42 est elle-même un circuit imprimé flexible.

De manière avantageuse, afin de positionner le support 40 à distance de la plaque 32 selon l'axe X32, l'enveloppe 22 comprend une cale 43, visible à la figure 2. La languette 42 est en appui contre la cale 43, et contrainte par la cale 43 pour positionner le support 40 en limitant les contraintes appliquées à ce dernier.

Le dispositif 20 comprend en outre un atténuateur 44, fixé au support 40. L'atténuateur 44 comprend un logement 46, comprenant un orifice de logement 48. L'orifice de logement 48 est traversant et s'étend selon un axe de logement R46. Le logement 46 est avantageusement circulaire, et en métal, par exemple en aluminium. Avantageusement, l'orifice de logement 48 est aligné avec l'orifice de support 41, de telle sorte que les axes de support R40 et de logement R46 coïncident.

L'atténuateur 44 comprend également une membrane d'atténuation 50, reçue dans le logement 46 et recouvrant l'orifice de logement 48. La membrane d'atténuation 50 est avantageusement formée d'un matériau étanche à l'air, par exemple du polyimide. Avantageusement, une épaisseur de la membrane d'atténuation 50, mesurée selon l'axe X32, est inférieure à 100µm, par exemple égale à 75µm.

Avantageusement, l'atténuateur 44 comprend également une rondelle 52. La rondelle 52 comprend un orifice de rondelle 54, traversant et s'étendant selon un axe de rondelle R52. Avantageusement, l'orifice de rondelle 54 a un diamètre d54 inférieur à 4mm, par exemple égal à 3,5mm et égal à un diamètre d48 de l'orifice de logement 48. La rondelle 52 est avantageusement en métal, par exemple en aluminium. La rondelle 54 est reçue dans le logement 46, par exemple en étant sertie dans le logement 46, de sorte que le logement 46 et la rondelle 52 soient chacun en contact avec la membrane d'atténuation 50. La membrane d'atténuation 50 recouvre ainsi à la fois l'orifice de logement 48 et l'orifice de rondelle 54. La membrane 50 est ainsi exposée à l'air par l'orifice de logement 40 et par l'orifice de rondelle 54, tout en étant étanche à l'air, comme décrit précédemment.

De manière avantageuse, la rondelle 54 est reçue dans le logement 46 de sorte que les axes de logement R46 et de rondelle R52 coïncident. Ainsi, les axes de support R40, de support R46 et de rondelle R52 coïncident.

Avantageusement, l'atténuateur 44 est fixé au support 40 par un film adhésif 60. Le film adhésif 60 comprend au moins deux couches adhésives 62 et au moins une membrane 64, interposée entre deux des au moins deux couches adhésives 62. Le film adhésif 60 est visible aux figures 2 et 3, et dans l'exemple des figures 2 et 3, comprend trois couches adhésives 62 double-face et deux membranes 64, chaque membrane 64 étant interposée entre deux couches adhésives 62. Les couches adhésives 62 et les membranes 64 sont ainsi collées les unes aux autres. Afin de fixer l'atténuateur 44 au support 40, l'une des couches adhésives 62 est collée à l'atténuateur 44 et une autre des couches adhésives 62 est collée au support 40.

Avantageusement, les couches adhésives 62 comprennent chacune un orifice 66, traversant, chaque orifice 66 étant selon un axe de film R60. Avantageusement, le diamètre des orifices 66 est variable, ainsi que visible sur la figure 2. En variante, les orifices 66 des couches adhésives 62 ont tous le même diamètre. Les membranes 64 ne comprennent pas d'orifice et recouvrent donc les orifices 66.

Avantageusement, les membranes 64 comprennent des fibres tissées, ou en variante, des fibres non tissées.

Avantageusement, les membranes 64 sont étanches à l'air, et le film adhésif 60 étanchéifie l'atténuateur 44 et l'orifice de support 41 à l'air.

Le dispositif 20 comprend également un microphone 70, fixé sur le support 40, le support 40 s'étendant entre le microphone 70 et l'atténuateur 44. Avantageusement, le microphone 70 recouvre l'orifice de support 41. Le microphone 70 est avantageusement un microphone à microsystèmes électromécaniques, ou MEMS, de l'anglais « Micro-Electromechanical System ». Le microphone 70 est connecté à l'unité électronique de contrôle 38, per exemple en étant connecté à l'un des composants électroniques 34. Le microphone 70 est configuré pour mesurer un bruit ambiant, c'est-à-dire les vibrations mécaniques de l'air qui l'entoure. Dans le cas où le microphone 70 est un microphone MEMS, il est configuré pour mesurer des bruits jusqu'à environ 135dB, au-delà de quoi il sature.

De manière avantageuse, le dispositif 20 comprend en outre un amortisseur mécanique 74. L'amortisseur mécanique 74 est fixé à l'enveloppe 22, et avantageusement, est en appui contre la plaque 32. L'amortisseur mécanique 74 entoure le support 40 et l'atténuateur 44. En particulier, l'amortisseur mécanique 74 comprend une ouverture centrale 76, traversante, et s'étendant selon un axe d'amortisseur R74, dans laquelle le support 40 est inséré, bouchant l'ouverture centrale 76.

De manière avantageuse, l'amortisseur mécanique 74 est formée d'un matériau élastomère, comme le silicone. L'amortisseur mécanique 74 est avantageusement monté serré autour du support 40, le support 40 étant inséré dans l'ouverture centrale 76 par exemple par déformation élastique ou plastique de l'amortisseur mécanique 74.

L'amortisseur mécanique 74 laisse libre le microphone 70 et l'orifice de logement 48, c'est-à-dire que l'amortisseur mécanique 74 n'est pas en contact avec ces derniers, par exemple ne recouvre pas l'orifice de logement 48.

De manière avantageuse, la cale 43 et la languette 42 permettent de positionner le support 40 de telle sorte à limiter les contraintes exercées par le support 40 sur l'amortisseur mécanique 74.

Un fonctionnement du dispositif est maintenant expliqué.

Lorsque le disjoncteur 12 bascule en configuration déclenchée suite à un défaut de type surcharge ou court-circuit, ou suite à une commande de l'utilisateur, le disjoncteur 12 génère du bruit, représentatif de l'intensité de déclenchement I_{d}, ainsi que des vibrations mécaniques dans les pièces solides formant le disjoncteur 12. En particulier, le bruit généré est causé par des détonations, et par des variations de pression dites acoustiques, qui sont représentatives de l'intensité de déclenchement. Les détonations peuvent causer des variations de pression jusqu'à plusieurs centaines de milliers de pascals, qui peuvent endommager le microphone 70. Les variations de pressions acoustiques sont par exemple de l'ordre du millier de pascals, et les variations de pressions acoustiques maximales sont par exemple de l'ordre de 6000 Pa, soit de l'ordre de 169,5 dB.

L'atténuateur 44, en particulier grâce à la membrane d'atténuation 50, atténue le bruit généré par le disjoncteur 12 lorsqu'il bascule en configuration déclenchée. Plus précisément, l'atténuateur 44 atténue à la fois les détonations, protégeant ainsi le microphone 70, et les variations de pression acoustiques. De manière avantageuse, l'atténuateur 44 atténue les variations de pression acoustiques de sorte à obtenir en entrée du microphone 70 un bruit atténué généré par des valeurs maximales de variations de pression de l'ordre de 135dB, ce qui limite les risques de saturation du microphone 70. Ainsi, lorsque le microphone 70 reçoit le bruit atténué par l'atténuateur 44, il est capable de le mesurer.

De plus, l'atténuateur 44 atténue les variations de pression acoustiques de manière constante, indépendamment d'une fréquence de ces dernières. En pratique, l'atténuateur 44 atténue les variations de pression de manière constante pour un spectre de fréquence prédéfini. Par exemple, le spectre de fréquence est compris entre 20Hz et 15kHz, de préférence compris entre 30Hz et 10kHz. Autrement dit, le bruit atténué n'est pas déformé sur le spectre de fréquence compris entre 30Hz et 10kHz. Ainsi, le bruit atténué est représentatif du bruit généré par le disjoncteur 12, et donc, de l'intensité de déclenchement I_{d}.

Le microphone 70 mesure le bruit ambiant, qui est, dans le cas du dispositif 20, le bruit atténué par l'atténuateur 44, et génère un signal de sortie, représentatif du bruit atténué. L'unité électronique de contrôle 38 reçoit le signal de sortie émis par le microphone 70, et estime l'intensité de déclenchement I_{d} du courant de déclenchement du disjoncteur 12, à partir du signal de sortie. De manière avantageuse, le signal de sortie est pris en compte par l'unité électronique de contrôle 38 seulement lorsque l'unité électronique de contrôle 38 reçoit une commande d'acquisition, émise par exemple par un micro-contact. Le micro-contact est configuré pour détecter le déclenchement du disjoncteur 12 et émet alors la commande d'acquisition.

Les vibrations mécaniques générées par le disjoncteur 12 sont transmises au dispositif 20, notamment par le biais de l'enveloppe 22, qui la transmet ensuite à la plaque 32. Afin d'éviter leur transmission au microphone 70, les vibrations mécaniques sont atténuées par l'ensemble formé du support 40 et de la languette 42 et avantageusement, par l'amortisseur mécanique 74. L'ensemble formé du support 40 et de la languette 42 permet de désolidariser le support 40 de la plaque 32, et donc de limiter la transmission des vibrations mécaniques du disjoncteur 12 au support 40, et donc au microphone 70 fixé sur le support 40. L'amortisseur mécanique 74 réduit les vibrations mécaniques malgré tout transmises à la languette 42 et au support 40. Ainsi, les vibrations mécaniques transmises au microphone 70 à partir du support 40 sont limitées, évitant de masquer le bruit atténué obtenu à partir du bruit produit par le disjoncteur 12.

Le bruit et les vibrations mécaniques générés par le disjoncteur 12 causent des phénomènes de résonance, générant du bruit supplémentaire, dont la fréquence est par exemple comprise entre 20kHz et 35kHz. De manière avantageuse, les membranes 64 atténuent les bruits de fréquence supérieure à 20kHz, sans atténuer les autres bruits, limitant ainsi un risque de saturation du microphone 70 causé par les phénomènes de résonance. Les membranes 64 fonctionnent ainsi comme des impédances acoustiques.

L'atténuateur 44, l'ensemble formé du support 40 et de la languette 42, et avantageusement, l'amortisseur mécanique 74 et les membranes 64 limitent la présence de parasites dans le signal de sortie, et permettent ainsi une estimation la plus précise possible de l'intensité de déclenchement I_{d} par l'unité électronique de contrôle 38.

## Revendications

1. Dispositif acoustique (20) pour l'estimation d'une intensité de déclenchement (I_{d}) d'un courant de déclenchement circulant dans un disjoncteur (12), le dispositif (20) comprenant :
- une enveloppe (22) configurée pour être fixée au disjoncteur (12) ;
- un microphone (70) ;
- une unité électronique de contrôle (38), connectée au microphone (70) ; **caractérisé en ce que** le dispositif (20) comprend en outre :
- une plaque (32), intégrée à l'intérieur de l'enveloppe (22), la plaque (32) s'étendant selon un plan principal (P) ;
- un support (40), intégré à l'intérieur de l'enveloppe (22), le support (40) s'étendant parallèlement au plan principal (P), une languette (42) reliant le support (40) et la plaque (32), le support (40) étant relié à la plaque (32) uniquement par l'intermédiaire de la languette (42) ;
- le microphone (70) étant fixé au support (40) ;
- un atténuateur (44), fixé au support (40), le support (40) s'étendant entre le microphone (70) et l'atténuateur (44), l'atténuateur (44) comprenant :
o un logement (46) comprenant un orifice de logement (48), traversant et s'étendant selon un axe de logement (R46), et
o une membrane d'atténuation (50), reçue dans le logement (46) et recouvrant l'orifice de logement (48) ; et
l'atténuateur (44) étant configuré pour atténuer un bruit généré par le disjoncteur (12), le bruit étant représentatif de l'intensité de déclenchement (I_{d}), le microphone (70) étant configuré pour mesurer le bruit atténué par l'atténuateur (44), et pour émettre un signal de sortie représentatif du bruit atténué, et l'unité électronique de contrôle (38) étant configurée pour recevoir le signal de sortie émis par le microphone (70) et pour estimer l'intensité de déclenchement (I_{d}) du courant de déclenchement du disjoncteur (12), à partir du signal de sortie.

2. Dispositif (20) selon la revendication 1, dans lequel l'atténuateur (44) comprend en outre une rondelle (52), comprenant un orifice de rondelle (54), l'orifice de rondelle (54) étant traversant et s'étendant selon un axe de rondelle (R52), la rondelle (52) étant reçue dans le logement (46) de sorte que les axes de logement (R46) et de rondelle (R52) coïncident, la rondelle (52) étant en contact avec la membrane d'atténuation (50), et la membrane d'atténuation (50) recouvrant l'orifice de rondelle (54).

3. Dispositif selon l'une quelconque des revendications précédentes, comprenant en outre un amortisseur mécanique (74), fixé à l'enveloppe (22), entourant le support (40) et l'atténuateur (44), et laissant libre le microphone (70) et l'orifice de logement (48), l'amortisseur mécanique (74) étant configuré pour amortir des vibrations mécaniques du dispositif (20).

4. Dispositif (20) selon l'une quelconque des revendications précédentes, dans lequel l'enveloppe (22) comprend une cale (43), la languette (42) étant en appui contre la cale (43) afin de positionner le support (40) à distance de la plaque (32) selon un axe perpendiculaire (X32) au plan principal (P).

5. Dispositif (20) selon l'une quelconque des revendications précédentes, dans lequel :
- le support (40) comprend un orifice de support (41), l'orifice de support (41) étant traversant selon un axe de support (R40) ;
- le microphone (70) est fixé sur le support (40) de manière à recouvrir l'orifice de support (41) ; et
- l'atténuateur (44) est fixé au support (40) de sorte que les axes de logement (R46), de rondelle (R52) et de support (R40) coïncident.

6. Dispositif (20) selon l'une quelconque des revendications précédentes, dans lequel l'enveloppe (22) comprend un port acoustique (28), comprenant au moins une ouverture, le support (40) est en regard du port acoustique (28) et l'atténuateur (44) est disposé entre le support (40) et le port acoustique (28).

7. Dispositif (20) selon l'une quelconque des revendications précédentes, dans lequel l'atténuateur (44) est fixé au support (40) par un film adhésif (60), le film adhésif (60) comprenant au moins deux couches adhésives (62) et au moins une membrane (64), interposée entre deux parmi les au moins deux couches adhésives (62), une des au moins deux couches adhésives (62) étant collée à l'atténuateur (44) et une autre des au moins deux couches adhésives (62) étant collée au support (40).

8. Dispositif (20) selon la revendication 7, dans laquelle la ou chaque membrane (64) comprend des fibres tissées.

9. Dispositif (20) selon la revendication 7, dans laquelle la ou chaque membrane (64) comprend des fibres non tissées.

10. Ensemble de protection électrique (10) comprenant un disjoncteur (12), le disjoncteur étant configuré pour être connecté entre une source (3) et une charge (5), et étant configuré pour basculer d'une configuration armée, dans laquelle le disjoncteur (12) conduit un courant circulant entre la source (3) et la charge (5), à une configuration déclenchée, dans laquelle le disjoncteur (12) isole électriquement la charge (5) de la source (3), lorsqu'un courant de déclenchement d'intensité l'intensité de déclenchement (I_{d}) circule dans le disjoncteur (12), le basculement du disjoncteur (12) de la configuration armée à la configuration déclenchée générant un bruit, représentatif de l'intensité de déclenchement (I_{d}), le disjoncteur (12) comprenant un boîtier (14), l'ensemble de protection électrique comprenant en outre un dispositif (20) selon l'une quelconque des revendications 1 à 9, l'enveloppe (22) du dispositif (20) étant fixée sur le boîtier (14).

11. Installation électrique (1) comprenant une source (3), une charge (5) connectée à la source (3) et un ensemble de protection électrique (10) selon la revendication 9, connecté entre la source (3) et la charge (5).
